# EUROPÄISCHE PATENTSCHRIFT

(11) **EP 2 850 395 B1**
(45) Veröffentlichungstag und Bekanntmachung des Hinweises auf die Patenterteilung: **04.01.2017**
(21) Anmeldenummer: 13713143.9
(22) Anmeldetag: 25.03.2013
(51) Int. Cl.: G01D 5/244, H03M 1/12, G01D 5/12, G01D 5/14, H03M 1/16, G01D 3/032, H03M 1/06, H04B 15/00, H04L 7/02, H04L 27/10

(54) **VERFAHREN ZUR ENTSTÖRUNG EINES ABTASTPROZESSES SOWIE EINE VORRICHTUNG ZUR DURCHFÜHRUNG DES VERFAHRENS**
METHOD FOR INTERFERENCE SUPPRESSION OF A SAMPLING PROCESS AND A DEVICE FOR IMPLEMENTING THE METHOD
PROCÉDÉ DE DÉPARASITAGE D'UN PROCESSUS D'ÉCHANTILLONNAGE AINSI QUE DISPOSITIF POUR EXÉCUTER LEDIT PROCÉDÉ

(30) Priorität: 16.05.2012 DE 102012208281
(43) Veröffentlichungstag der Anmeldung: 25.03.2015
(73) Patentinhaber: Robert Bosch GmbH, 70442 Stuttgart (DE)
(72) Erfinder: WUCHERT, Thomas, 36466 Dermbach (DE); KALISCH, Matthias, 70794 Filderstadt-Sielmingen (DE)
(86) Internationale Anmeldenummer: PCT/EP2013/056302
(87) Internationale Veröffentlichungsnummer: WO 2013/170989

(56) Entgegenhaltungen:
- DE-A1- 2 455 302
- DE-T2- 60 212 795
- BILINSKIS I ET AL: "DIGITAL ALIAS-FREE SIGNAL PROCESSING IN THE GHZ FREQUENCY RANGE", IEE COLLOQUIUM ON ADVANCED SIGNAL PROCESSING FOR MICROWAVEAPPLICATIONS, IEE, LONDON, GB, 29. November 1996 (1996-11-29), Seiten 6/01-6/06, XP001133893,

## Beschreibung

Die vorliegende Erfindung betrifft ein Verfahren zur Entstörung eines Abtastprozesses sowie eine Vorrichtung zur Durchführung des Verfahrens. Insbesondere betrifft die vorliegende Erfindung ein Verfahren zur Entstörung eines Abtastprozesses mit anschließender Analog-Digital-Wandlung gegenüber einem hochfrequenten Störer sowie eine gemäß dem Verfahren gegenüber einem hochfrequenten Störer entstörte Vorrichtung mit Analog-Digital-Wandler.

### Stand der Technik

Zur digitalen Auswertung der Messergebnisse von Sensoren ist es notwendig, das analoge Sensorsignal beziehungsweise das von Sensoren abgetastete Signal in ein digitales Signal zu wandeln. Häufig werden hierfür Analog-Digital-Wandler eingesetzt, die die Vorteile einer Überabtastung nutzen. Hierbei wird das schmalbandige Eingangssignal mit einem hochfrequenten Takt abgetastet und anschließend mit einem Analog-Digital-Wandler digitalisiert. Die Bandbreite des Nutzsignals (auch als Nutzband oder Basisband bezeichnet) ist dabei deutlich kleiner als die halbe Abtastfrequenz. Enthält das Eingangssignal hochfrequente Störsignale, so werden diese aufgrund des Alias-Effekts gegebenenfalls in das Nutzband heruntergefaltet. Um dies zu verhindern, wird üblicherweise ein Anti-Aliasing-Filter verwendet, das die hochfrequenten Störsignale vor der Abtastung herausfiltert.

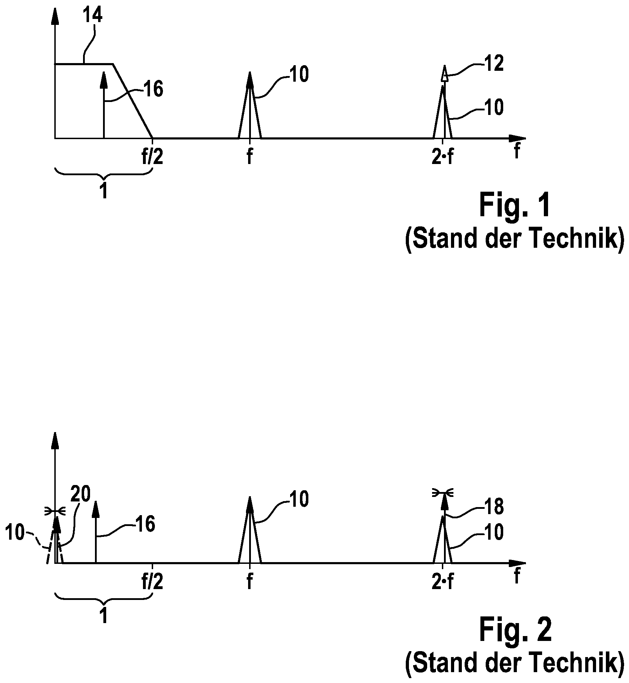

In Figur 1 ist schematisch ein Frequenzdiagramm für eine solche Situation dargestellt. Das analoge Nutzsignal 16 wird mit einer Abtastfrequenz f abgetastet. Bei einer idealisierten Schaltung beziehungsweise einem idealisierten Verfahren geschieht dies beispielsweise mit Hilfe eines periodischen Taktsignals mit der Periode T = 1/f, wobei jeweils zu einem bestimmten Zeitpunkt innerhalb der Periode, beispielsweise wenn das periodische Taktsignal eine bestimmte Spannung überschreitet oder unterschreitet, ein Abtastwert erfasst wird, so dass der zeitliche Abstand zwischen zwei aufeinanderfolgenden Abtastzeitpunkten jeweils der Periode T entspricht. Das abgetastete Nutzsignal ergibt sich dann in der Zeitdarstellung als Produkt des Eingangssignals mit einer Abtastfunktion, die durch eine Folge äquidistanter Abtastpulse im zeitlichen Abstand T gegeben ist. In der Frequenzdarstellung entspricht dieses Produkt einer Faltung des Frequenzspektrums des Eingangssignals mit dem Frequenzspektrum der Abtastfunktion, das durch eine Folge äquidistanter Spektrallinien im Abstand f gegeben ist. Das Frequenzspektrum 10 einer Abtastfunktion ist in Figur 1 dargestellt. Die um 0 * f zentrierte Komponente des Frequenzspektrums 10 der Abtastfunktion ist dabei der übersichtlicheren Darstellung halber nicht gezeigt.

In einer realen Schaltung treten unvermeidliche stochastische Abweichungen von diesem idealisierten Verhalten auf. Dadurch sind die Abtastzeitpunkte und damit die Abtastpulse in der Abtastfunktion gegenüber den idealisierten Abtastzeitpunkten leicht verschoben, was sich im Frequenzspektrum der Abtastfunktion 10 dadurch widerspiegelt, dass die idealisierten Spektrallinien über um die ganzzahligen Vielfachen der Abtastfrequenz f zentrierte Frequenzbereiche verschmiert und mit zunehmender Frequenz zunehmend gedämpft werden.

Das Eingangssignal kann überlagert hochfrequente Störsignale enthalten, wie sie beispielsweise bei elektromagnetischer Einkopplung auftreten. Gemäß dem Stand der Technik wird ein solches Störsignal vor dem Abtasten mit Hilfe eines Anti-Aliasing-Filters, beispielsweise eines Tiefpassfilters mit der Übertragungsfunktion 14, herausgefiltert. Ein solches, gefiltertes, hochfrequentes Störsignal 12 ist in Figur 1 beispielhaft bei einer Frequenz gezeigt, die knapp oberhalb des Zweifachen der Abtastfrequenz f liegt. Der Schnittpunkt der Übertragungsfunktion 14 des Anti-Aliasing-Filters mit der Frequenzachse begrenzt das Basisband 1 auf einen Bereich, der sich von 0*f bis zu einer Frequenz von f/2 erstreckt. Das Tiefpassfilter ist dabei so ausgebildet, dass ein analoges Nutzsignal 16 im Basisband 1 bei einer typischen Nutzfrequenz möglichst ungefiltert durchgelassen wird. Nachteilig an dieser Lösung ist, dass ein Anti-Aliasing-Filter implementiert werden muss. Insbesondere bei Realisierung auf einer anwendungsspezifischen integrierten Schaltung (ASIC) führt dies zu Entwicklungsaufwand und Flächenverbrauch.

Die Figur 2 zeigt die Frequenzspektren von der Abtastung eines analogen Nutzsignals 16 ohne Anti-Aliasing-Filter. Das Basisband 1 erstreckt sich wie im Falle der Filterung mit einem Anti-Aliasing-Filter über einen Frequenzbereich von 0*f bis f/2. Allerdings wird die Störamplitude 20, welche die Faltung eines ungefilterten, hochfrequenten Störers 18 im Fall der Abtastung ohne Verwendung des Anti-Aliasing-Filters darstellt, meist direkt in das Basisband 1 gefaltet und somit, bei der Abtastung mit einer Abtastfrequenz f, deren Frequenzspektrum 10 in Figur 2 gleich zu dem in Figur 1 eingezeichnet ist, fälschlicherweise als Nutzsignal 16 interpretiert.

Aus der DE 602 12 795 T2 ist ein Verfahren zur Abtastung eines analogen Eingangssignals und zur Abspeicherung einer digitalen Darstellung der Abtastwerte in einem Speicher bekannt, wobei eine Folge von Taktpulsen mit einer vorgegebenen Frequenz F_{dk} generiert und unter Zuhilfenahme generierter Pseudo-Zufallsfolgen alterniert werden. Die pseudo-zufällig alternierten Taktpulse werden zur Bildung einer Folge von Abtastpulsen verwandt.

Der in der DE 602 12 795 T2 beschriebene Gegenstand baut auf einer Lehre auf, welche in I.Bilinskis, G. Cain, Digital Alias-Free Signal Processing in the GHz Frequency Range, XP- 001133893, Institution of Electrical Engineers, 1996, p. 6/1-6/6 bechrieben ist.

Ferner ist aus der DT 24 55 302 A1 ein Verfahren zur Analog-Digital-Wandlung und digitalen Signalanalyse sowie eine Vorrichtung zum Ausüben des Verfahrens bekannt, wobei das analoge Eingangssignal einer Abtastung aus einander überlagerten äquidistanten und (wenigstens pseudo-) stochastisch variierten Abtastintervallen unterzogen wird.

### Offenbarung der Erfindung

Erfindungsgemäß wird ein Verfahren zur Entstörung eines Abtastprozesses zur Verfügung gestellt. Das Verfahren umfasst den Verfahrensschritt des Abtastens eines analogen Nutzsignals mit einer Abtastfrequenz f sowie des Bestimmens, ob eine Störamplitude vorliegt. Bei Vorliegen einer Störamplitude wird eine stochastische Verschiebung der durch die Abtastfrequenz f bestimmten zeitlich äquidistanten Abtastzeitpunkte innerhalb eines Bereichs [-Δt; +Δt] um die äquidistanten Abtastzeitpunkte herum vorgenommen, wobei Δt die maximale Verschiebung ist. Dann wird eine erneute Abtastung des analogen Nutzsignals durchgeführt. Es wird erneut bestimmt, ob eine Störamplitude vorliegt. Bei weiterem Vorliegen einer Störamplitude wird eine Veränderung des Betrags der maximalen Verschiebung |Δt| vorgenommen und erneut mit dem Verfahrensschritt der stochastischen Verschiebung der Abtastzeitpunkte begonnen. Das Abtastsignal wird also bei Vorliegen einer Störamplitude zunächst mit einem Jitter des Betrages 2Δt beaufschlagt. Die stochastisch verschobenen Abtastzeitpunkte, also die Abtastzeitpunkte, zu denen das analoge Nutzsignal abgetastet wird, variieren dann stochastisch innerhalb eines zeitlichen Bereichs mit den Grenzen [-Δt; +Δt] um die, durch die Abtastfrequenz f bestimmten, zeitlich äquidistanten Abtastzeitpunkte herum. Δt ist dabei die maximale Verschiebung, um die ein Abtastzeitpunkt gegenüber einem ursprünglichen, durch die Abtastfrequenz f gegebenen Abtastzeitpunkt verschoben sein kann. Das analoge Nutzsignal wird zu den stochastisch verschobenen Abtastzeitpunkten abgetastet und daraufhin erneut bestimmt, ob immer noch eine Störamplitude vorliegt. Ist dies der Fall, wird der Betrag der maximalen Verschiebung |Δt| verkleinert oder vergrößert, wodurch sich die Grenzen des Bereichs [-Δt; +Δt] ebenfalls verkleinern oder vergrößern. Die Grenzen können zum Beispiel halbiert [+Δt/2; -Δt/2], was einem Jitter mit dem Betrag Δt entspricht, verdoppelt [+2Δt; -2Δt], was einem Jitter mit dem Betrag 4Δt entspricht, oder beliebig anderweitig variiert werden. Da dabei die Abtastfrequenz konstant gehalten wird, bleibt auch das Basisband des Nutzsignals unverändert.

Der Vorteil eines solchen Verfahrens ist darin gegeben, dass bei einer Analog-Digital-Wandlung, die auf einen Anti-Aliasing-Filter verzichtet, ein hochfrequenter Störer nicht mehr in das Basisband, sondern in einen Frequenzbereich gefaltet wird, welcher außerhalb des Basisbandes liegt und sich zudem die Störamplitude des hochfrequenten, heruntergefalteten Störers verringert. Somit kann das analog-digital-gewandelte Nutzsignal, durch die "Verjitterung" des Abtastsignals sowie durch die sukzessive Veränderung des Jitters, mit welchem des Abtastsignal beaufschlagt wird, auch ohne die Verwendung eines Anti-Aliasing-Filters, richtig interpretiert werden. Dadurch können Kosten sowie Platz bei der Implementierung eines Analog-Digital-Wandlers eingespart werden. Des Weiteren kommt es bei der Verwendung eines Anti-Aliasing-Filters auch zu einer unerwünschten Dämpfung des Nutzsignals, während nicht alle Frequenzanteile, die immer noch Alias-Effekte verursachen, durch das Anti-Aliasing-Filter unterdrückt werden können. Auch diese Nachteile lassen sich durch die Verwendung des erfindungsgemäßen Verfahrens umgehen.

In einer bevorzugten Ausführungsform des Verfahrens liegt in den Verfahrensschritten des Bestimmens, ob eine Störamplitude vorliegt, nur dann eine Störamplitude vor, wenn diese größer als ein Schwellwert ist. Der Vorteil einer solchen Ausführungsform ist, dass das Verfahren nur so lange ausgeführt wird, bis die Störamplitude kleiner als ein festgelegter Schwellwert ist beziehungsweise nur dann initiiert wird, wenn die Störamplitude einen vorbestimmten Schwellwert übersteigt. Der Schwellwert kann dabei zum Beispiel so gewählt werden, dass unter ihm liegende Störamplituden keine oder lediglich zu vernachlässigende Auswirkung auf die Korrektheit der Interpretation eines Nutzsignals haben. Dadurch gewinnt das Verfahren an Effizienz, da eine Anpassung des zur Störamplitudenunterdrückung vorgenommenen Aufwandes an den aus diesem resultierenden Nutzen erfolgt.

In einer bevorzugten Ausführungsform des Verfahrens umfasst dieses ferner den Schritt der Analog-Digital-Wandlung des abgetasteten Signals, wobei in den Verfahrensschritten des Bestimmens, ob eine Störamplitude vorliegt, nur dann eine Störamplitude vorliegt, wenn diese größer als das Rauschen einer im Rahmen des Verfahrens durchgeführten Analog-Digital-Wandlung ist. Auf diese Weise wird das für die Interpretation des Nutzsignals unerhebliche Rauschen einer im Rahmen des Verfahrens angewandten Analog-Digital-Wandlung als Auslöser für eine Veränderung der Abtastfrequenz ausgeschlossen. Dadurch gewinnt das Verfahren an Effizienz, da eine Anpassung des zur Störamplitudenunterdrückung vorgenommenen Aufwandes an den aus diesem resultierenden Nutzen erfolgt.

In einer bevorzugten Ausführungsform des Verfahrens liegt nur dann eine Störamplitude vor, wenn die Störamplitude im Basisband des Frequenzspektrums eines abgetasteten Nutzsignals vorliegt. Dadurch wird das Verfahren ausschließlich dann initiiert, wenn der Störer im Nutzband des Frequenzbereiches zum Tragen kommt, wodurch das Verfahren an Effizienz gewinnt.

In einer bevorzugten Ausführungsform des Verfahrens werden die Abtastzeitpunkte dadurch bestimmt, dass die Phase eines Taktsignals einen Schwellwert annimmt. Beispielsweise können die Abtastzeitpunkte durch Nulldurchgänge in der aufsteigenden Flanke des Taktsignals oder durch Nulldurchgänge in der absteigenden Flanke des Taktsignals bestimmt werden, oder allgemeiner dadurch, dass das Taktsignal einen Schwellwert überschreitet, oder dadurch, dass das Taktsignal einen Schwellwert unterschreitet.

In einer bevorzugten Weiterentwicklung dieser Ausführungsform des Verfahrens wird das Taktsignal dadurch erzeugt, dass ein periodisches Taktsignal mit der Periode 1/f mit Phasenrauschen beaufschlagt wird, das heißt, dass die Phase des Taktsignals zeitabhängig stochastisch verschoben wird. Das Phasenrauschen kann beispielsweise 1/f-Rauschen sein, das heißt ein Rauschsignal, dessen spektrale Leistungsdichte umgekehrt proportional zur Frequenz abnimmt. Vorteil einer solchen Ausführung ist, dass das Rauschen und somit der Jitter, mit welchem das Taktsignal beaufschlagt wird, getrennt von dem Taktsignal beeinflussbar ist.

Das Taktsignal kann aber beispielsweise auch dadurch erzeugt werden, dass ein periodisches Taktsignal mit der Periode 1/f einer Frequenzmodulation unterworfen wird, beispielsweise einer Frequenzmodulation mit einem sinusförmigen Modulationssignal.

Erfindungsgemäß kann jedes Verfahren zur Erzeugung eines Jitters im Taktsignal verwendet werden.

In einer bevorzugten Ausführungsform des Verfahrens ist in dem Schritt der Veränderung des Betrages der maximalen Verschiebung |Δt| das Verhältnis aus dem Betrag der Veränderung des Betrags der stochastischen Verschiebung der durch die Abtastfrequenz f bestimmten zeitlich äquidistanten Abtastzeitpunkte zu der Nutzfrequenz, größer oder gleich einem Wert von 1,25.

Die Nutzfrequenz entspricht dabei der Frequenz, mit der im Rahmen des Abtastverfahrens über die Zeit eine Veränderung der maximalen Verschiebung |Δt| erfolgt. Die Nutzfrequenz bleibt bei dem erfindungsgemäßen Verfahren konstant. Das Verhältnis aus dem Betrag der Veränderung des Betrags der stochastischen Verschiebung der durch die Abtastfrequenz f bestimmten zeitlich äquidistanten Abtastzeitpunkte zu der Nutzfrequenz kann auch als Modulationsindex bezeichnet werden. Eine Variation des Modulationsindex kann, da die Nutzfrequenz bei der Durchführung des Verfahrens konstant ist, nur über eine Variation des Betrags der Veränderung des Betrages der stochastischen Verschiebung der durch die Abtastfreqeunz f bestimmten zeitlich äquidistanten Abtastzeitpunkte erfolgen. Wird bei der Durchführung des Verfahrens der Modulationsindex auf einem Wert ≥ 1,25 gehalten, funktioniert das Verfahren besonders effizient.

Vorzugsweise entspricht das anfängliche Δt einem Wert von ]0; 2 %], bevorzugt ]0; 1 %] der Abtastfrequenz. Mit anderen Worten ist Δt größer 0 % und kleiner gleich 2 % der Abtastfrequenz, bevorzugt größer 0 % und kleiner gleich 1 % der Abtastfrequenz gewählt.

In einer bevorzugten Ausführungsform wird das anfängliche Δt im Schritt der Veränderung des Bereichs [-Δt; +Δt] halbiert.

Erfindungsgemäß wird ferner eine Vorrichtung zur Entstörung eines Abtastprozesses bereitgestellt, umfassend ein Mittel zum Abtasten eines Nutzsignals mit einer Abtastfrequenz, und ein Mittel zur Störamplitudenbestimmung, welches dazu ausgelegt ist zu bestimmen, ob dass abgetastete Nutzsignal mit einer Störamplitude beaufschlagt ist. Das Mittel zur Störamplitudenbestimmung ist ferner dazu ausgelegt, bei Vorliegen einer Störamplitude, die durch die Abtastfrequenz f bestimmten zeitlich äquidistanten Abtastzeitpunkte innerhalb eines Bereichs um die äquidistanten Abtastzeitpunkte herum stochastisch zu verschieben, wobei Δt die maximale Verschiebung ist. Die Vorrichtung ist dann anschliessend dazu ausgelegt, das Nutzsignal mit den stochastisch verschobenen Abtastzeitpunkten erneut abzutasten, und bei weiterem Vorliegen einer Störamplitude, den Betrag der maximalen Verschiebung |Δt| zu verändern.

In einem Ausführungsbeispiel umfasst die Vorrichtung einen Taktgeber, der dazu ausgelegt ist, ein periodisches Taktsignal zu erzeugen und mit einem Mittel zur Beaufschlagung verbunden ist. Das Mittel zur Beaufschlagung ist mit einer Rauschquelle verbunden und dazu ausgelegt, das Taktsignal mit einem von der Rauschquelle generierten Rauschsignal zu beaufschlagen und ein auf diese Weise verjittertes Taktsignal zu erzeugen. Die Rauschquelle ist dazu ausgelegt, die mittlere Rauschleistung des Rauschsignals bei Empfang eines Steuersignals zu vergrößern oder zu verkleinern. Ferner umfasst die Vorrichtung ein Mittel zur Abtastung, welches mit dem Mittel zur Beaufschlagung verbunden und dazu ausgelegt ist, ein analoges Nutzsignal mittels des verjitterten Taktsignals abzutasten und ein auf diese Weise abgetastetes Nutzsignal einem Analog-Digital-Wandler zuzuführen. Der Analog-Digital-Wandler ist dazu ausgelegt, das abgetastete Nutzsignal zu digitalisieren und das digitale Nutzsignal einem Mittel zu Störamplituden-Bestimmung zuzuführen. In dem Mittel zur Störamplituden-Bestimmung wird bestimmt, ob das digitale Nutzsignal mit einer Störamplitude baufschlagt ist. Bei Vorliegen einer Störamplitude wird in dem Mittel zur Störamplituden-Bestimmung ein Steuersignal zur stochastischen Veränderung der Abtastzeitpunkte generiert und der Rauschquelle zugeführt.

### Zeichnungen

Ausführungsbeispiele der Erfindung werden anhand der Zeichnungen und der nachfolgenden Beschreibung näher erläutert. Es zeigen:
Figur 1 die Frequenzspektren von der Abtastung eines Nutzsignals mit Anti-Aliasing-Filter des Standes der Technik,
Figur 2 die Frequenzspektren von der Abtastung eines Nutzsignals ohne Anti-Aliasing-Filter des Standes der Technik,
Figur 3 die Frequenzspektren von einer speziellen Abtastung eines Nutzsignals mit dem erfindungsgemäßen Verfahren,
Figur 4 ein Blockdiagramm eines Ausführungsbeispiels einer erfindungsgemäßen Vorrichtung, und
Figur 5 das Frequenzspektrum der Abtastung nach dem erfindungsgemäßen Verfahren über einen Zeitabschnitt.

### Ausführungsformen der Erfindung

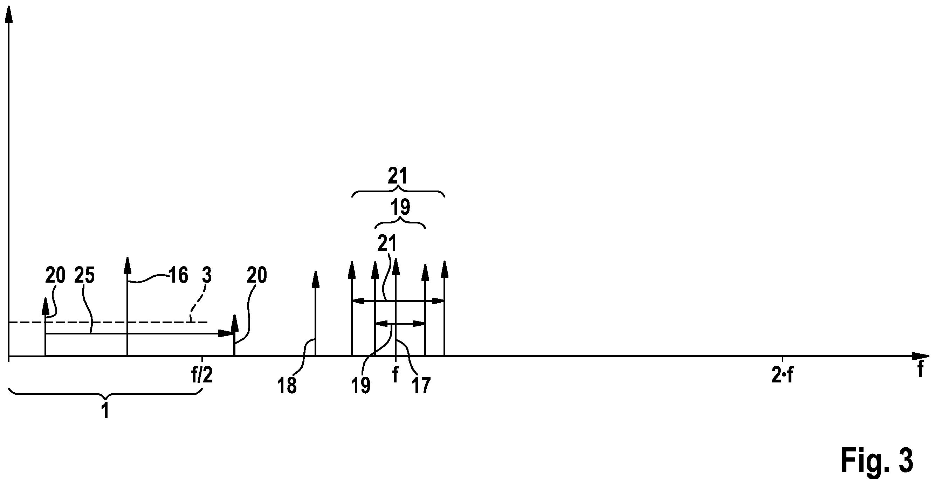

In der Figur 3 sind die Frequenzspektren von einer speziellen Abtastung eines Nutzsignals unter Verwendung des erfindungsgemäßen Verfahrens aufgezeigt. Das Basisband 1 erstreckt sich über den Frequenzbereich von 0f bis f/2. Ein analoges Nutzsignal 16 wird mit einer Abtastfrequenz 17 abgetastet. Liegt die Störamplitude 20 eines hochfrequenten, ungefilterten Störers 18 vor, wird diese Störamplitude 20 im Rahmen des erfindungsgemäßen Verfahrens erkannt. Es wird daraufhin eine stochastische Verschiebung der durch die Abtastfrequenz f bestimmten zeitlich äquidistanten Abtastzeitpunkte innerhalb eines Bereichs [-Δt; +Δt] 21 um die äquidistanten Abtastzeitpunkte herum vorgenommen. Der Wert Δt definiert als die maximale Verschiebung dabei die Grenzen des Bereichs [-Δt; +Δt] 21, in dem die Abtastzeitpunkte liegen, zu denen das analoge Nutzsignal 16 nach Erkennung einer Störamplitude 20 abgetastet wird. Die stochastische Verschiebung der tatsächlichen Abtastzeitpunkte wird dabei durch einen Jitter realisiert, mit dem die Abtastfrequenz 17 beaufschlagt wird. Die tatsächlichen Abtastzeitpunkte müssen dabei nicht genau um -Δt beziehungsweise +Δt von den durch die Abtastfrequenz 17 bestimmten zeitlich äquidistanten Abtastzeitpunkten abweichen. Vielmehr ist der Betrag der Abweichung von Abtastung zu Abtastung verschieden, bewegt sich jedoch innerhalb des Bereichs [-Δt; +Δt] 21. Das analoge Nutzsignal 16 wird zu den stochastisch verschobenen Abtastzeitpunkten abgetastet und im Anschluss daran erneut bestimmt, ob eine Störamplitude 20 vorliegt. Bei weiterem Vorliegen einer Störamplitude 20 wird der Betrag der maximalen Verschiebung |Δt| vergrößert oder verkleinert und damit der Bereich [-Δt; +Δt] 21 auf einen veränderten Bereich 19 verändert. In dem speziellen Ausführungsbeispiel, welches in Figur 3 dargestellt ist, kommt es rein beispielhaft zu einer Verkleinerung des Betrages |Δt| und damit einhergehend zu einer Verkleinerung des Bereichs [-Δt; +Δt] 21 durch eine rein beispielhafte Halbierung von |Δt|. Der veränderte Bereich 19 kann gegenüber dem ursprünglichen oder vorhergehenden Bereich 21 jedoch auch vergrößert sein. Im Anschluss daran wird erneut mit dem Verfahrensschritt der stochastischen Verschiebung der Abtastzeitpunkte, diesmal um den veränderten Bereich 19, begonnen. Der Bereich [-Δt; +Δt] 21, innerhalb dem anfänglich eine stochastische Verschiebung der durch die Abtastfrequenz f bestimmten zeitlich äquidistanten Abtastzeitpunkte um die äquidistanten Abtastzeitpunkte herum verfahrensgemäß vorgenommen wird, ist in dem hier dargestellten, speziellen Ausführungsbeispiel durch ein Δt begrenzt, welches größer als 0 % und kleiner gleich 2 % der Abtastfrequenz ist. Der Bereich kann aber auch beliebig anders, beispielsweise mit [-x; +y], gewählt werden, wobei x und y Elemente aus der Menge der reellen Zahlen sind. Bei der in Figur 3 dargestellten, speziellen Ausführung des Verfahrens wird eine Störamplitude 20 nur dann erkannt, wenn diese größer als das Rauschen 3 einer im Rahmen des Verfahrens durchgeführten Analog-Digital-Wandlung ist, und die Störamplitude 20 zusätzlich im Basisband 1 zum Liegen kommt. Der Schwellwert, ab dem eine Störamplitude erkannt wird, kann aber auch beliebig größer oder kleiner als das Rauschen gewählt werden. Der Bereich [-Δt; +Δt] 21, um den die Abtastfrequenz verjittert wird, wird in dem hier vorliegenden speziellen Ausführungsbeispiel so lange verfahrensgemäß verändert, bis keine Störamplitude 20 mehr im Basisband 1 bestimmt werden kann. Durch die Anwendung des Verfahrens kommt es so zu einer Verschiebung 25 der zuvor in das Basisband 1 gefalteten Störamplitude 20 des hochfrequenten, ungefilterten Störers 18 hinein in einen Frequenzbereich, der außerhalb des Basisbandes 1 liegt.

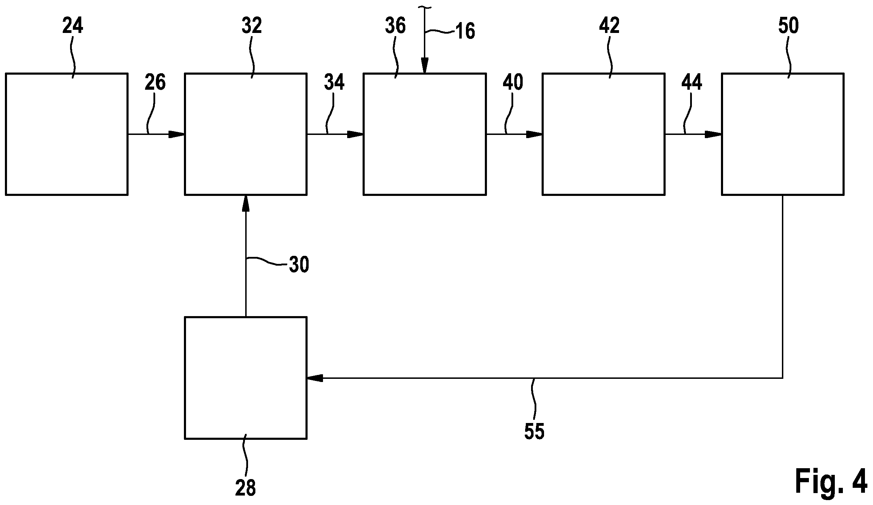

In der Figur 4 ist ein Blockdiagramm eines Ausführungsbeispiels einer erfindungsgemäßen Vorrichtung dargestellt. Ein Taktgeber 24 erzeugt ein periodisches Taktsignal 26, beispielsweise ein sinusförmiges oder ein rechteckförmiges Taktsignal. Der Taktgeber 24 ist mit einem Mittel zur Beaufschlagung 32 verbunden, welches dazu ausgelegt ist, ein Taktsignal 26 mit einem Rauschsignal 30 zu beaufschlagen und ein auf diese Weise verjittertes Taktsignal 34 zu generieren und einem Mittel zur Abtastung 36 zuzuführen. Das Mittel zur Beaufschlagung 32 ist des Weiteren mit einer Rauschquelle 28 verbunden, welche dazu ausgelegt ist, ein Rauschsignal 30, beispielsweise ein 1/f-Rauschen beziehungsweise ein Phasenrauschen, zu erzeugen und einem Mittel zur Beaufschlagung 32 zuzuführen sowie die mittlere Rauschleistung des Rauschsignals 30 bei Empfang eines Steuersignals 55 zu vergrößern oder zu verkleinern. In dem Mittel zur Abtastung 36 wird bei Vorliegen einer Störamplitude 20, ein analoges Nutzsignal 16, welches dem Mittel zur Abtastung 36 ebenfalls zugeführt wird, mittels des verjitterten Taktsignals 34 abgetastet und das auf diese Weise abgetastete Nutzsignal 40 einem Analog-Digital-Wandler 42 zugeführt. Beispielsweise tastet das Mittel zur Abtastung 36 das analoge Nutzsignal 16 ab, wenn das verjitterte Taktsignal 34 einen bestimmten Wert überschreitet, beispielsweise bei einem Nulldurchgang in der aufsteigenden Flanke. Der Analog-Digital-Wandler 42 ist dazu ausgelegt, das abgetastete Nutzsignal 40 zu digitalisieren und das digitale Nutzsignal 44 einem Mittel zur Störamplituden-Bestimmung 50 zuzuführen. In diesem wird bestimmt, ob das digitale Nutzsignal 44 mit einer Störamplitude beaufschlagt ist, beziehungsweise, ob eine Störamplitude vorliegt. Bei Vorliegen einer Störamplitude wird in dem Mittel zur Störamplituden-Bestimmung 50 ein Steuersignal 55 generiert und der Rauschquelle 28 zugeführt. In der Rauschquelle 28 wird daraufhin die mittlere Rauschleistung vergrößert oder verkleinert. Das Verfahren wird mit verändertem Rauschsignal 30 und damit einhergehend, mit veränderter maximaler Verschiebung Δt und verändertem Bereich [-Δt; +Δt] fortgesetzt. In diesem speziellen Ausführungsbeispiel bilden das Mittel zur Beaufschlagung 32, das Mittel zur Abtastung 36, der Analog-Digital-Wandler 42, das Mittel zur Störamplituden-Bestimmung 50 sowie die Rauschquelle 28 zusammen einen geschlossenen Regelkreis, über welchen die Veränderung der maximalen Verschiebung Δt und des Bereichs [-Δt; +Δt] erfolgt. Allerdings stellt dieses Ausführungsbeispiel nur eine mögliche Vorrichtung zur Ausführung des erfindungsgemäßen Verfahrens dar. Auch die Verjitterung des Taktsignals 26 kann auf andere Art und Weise, beispielsweise ohne Rauschquelle 28 durch direkte Einflussnahme auf den Taktgeber 24 erfolgen.

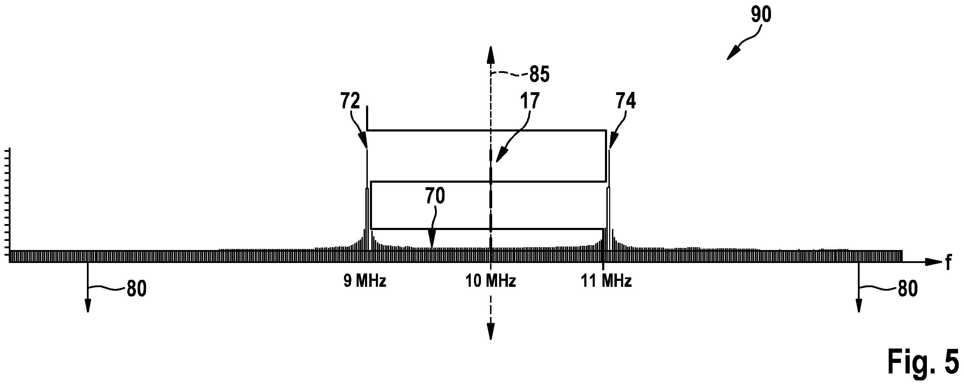

In der Figur 5 ist ein Frequenzspektrum der Abtastung nach einer bevorzugten Ausführungsform des erfindungsgemäßen Verfahrens über einen nicht näher bestimmten Zeitabschnitt dargestellt. Dabei ist die unverjitterte Abtastfrequenz 17 ohne stochastische Verschiebung der Abtastzeitpunkte zur Orientierung beispielhaft bei einem Wert von 10 MHz gestrichelt eingezeichnet. Alle anderen eingezeichneten Frequenzspektren ergeben sich aus Abtastungen mit gegenüber der Abtastfrequenz 17 um einen jeweils verschiedenen Betrag +/- Δt verschobenen Abtastzeitpunkt. Eine willkürlich herausgegriffene Abtastung 70 ist in Figur 5 mit einem Pfeil indiziert. Sie liegt rein beispielhaft bei 9,5 MHz. Das Frequenzspektrum mit der in Figur 5 maximalen Amplitude ist dabei in diesem Ausführungsbeispiel mit einer willkürlich gewählten Nutzfrequenz bei einem Betrag von ungefähr 9 MHz beziehungsweise 11 MHz gegeben. In diesem Ausführungsbeispiel erfolgt die Veränderung des Betrags der stochastischen Verschiebung der durch die Abtastfrequenz f 17 bestimmten zeitlich äquidistanten Abtastzeitpunkte nach einem bestimmten Muster: Der Betrag der Veränderung des Betrags der stochastischen Verschiebung von Abtastung zu Abtastung ist dabei konstant und so gewählt, dass die zu dieser Wahl korrespondierenden Frequenzspektren von Abtastung zu Abtastung um das Frequenzspektrum der unverjitterten Abtastfrequenz, mit jeweils ungefähr gleichem Abstand zu dieser, oszillieren. In dem in Figur 5 dargestellten Ausführungsbeispiel tastet das erfindungsgemäße Verfahren das Nutzsignal zunächst beispielsweise zu einem stochastisch um ein -Δt verschobenen Abtastzeitpunkt ab, dessen Frequenzspektrum 72 rein beispielhaft bei einem Wert von ca. 9 MHz, also ca. 1 MHz unter der unverjitterten Abtastfrequenz liegt. Im Anschluss daran erfolgt die nächste Abtastung zu einem stochastisch um ein +Δt verschobenen Abtastzeitpunkt, so dass deren Frequenzspektrum 74 bei einem Wert von ca. 11 MHz, also ca. 1 MHz über der unverjitterten Abtastfrequenz liegt. Die darauf folgende Abtastung führt wieder zu dem Frequenzspektrum 72 und beginnt von dort wie oben dargestellt erneut, so dass die Abtastung in diesem speziellen Ausführungsbeispiel immer abwechselnd mit dem Frequenzspektrum 72 bei ca. 9 MHz und dem Frequenzspektrum 74 bei ca. 11 MHz erfolgt. Der Modulationsindex bleibt also konstant. Denkt man sich eine Zeitachse 85 durch das Frequenzspektrum der unverjitterten Abtastfrequenz 17 und verschiebt das Diagramm 90 der Figur 5 entlang der Richtung 80 und entlang der gedachten Zeitachse 85 während der Durchführung des erfindungsgemäßen Verfahrens, so ergibt die Verbindung der Spitzen der Amplituden der Frequenzspektren 72, 74 der Abtastungen eine Folge von Rechtecken beziehungsweise eine mäanderförmige Struktur. Es können auch alternativ leichte Schwankungen der Amplituden zugelassen werden, so dass die Kanten dieser Rechtecke verschliffen beziehungsweise nicht mehr parallel zu der gedachten Zeitachse beziehungsweise der Frequenzachse sind (in Figur 5 nicht dargestellt). In einer weiteren Ausführungsform, die in Figur 5 ebenfalls nicht dargestellt ist, ergibt die Verbindung der Amplituden der Frequenzspektren der Abtastung entlang der gedachten Zeitachse einen sinusförmigen Verlauf. Die Frequenzwerte, bei denen die Frequenzspektren der Abtastung in diesem Ausführungsbeispiel liegen, ergeben sich unter anderem aus dem Zusammenspiel von Abtastfrequenz, Nutzfrequenz sowie den jeweiligen Beträgen der stochastischen Verschiebung der Abtastzeitpunkte und sind in der Figur 5 rein beispielhaft gewählt.

In allen Ausführungsbeispielen kann als Mindestwert für den Betrag der Veränderung des Betrages der maximalen Verschiebung |Δt| ein Modulationsindex ≥1,25 festgelegt werden. Das Verhältnis aus dem Betrag der Veränderung des Betrages der stochastischen Verschiebung der durch die Abtastfrequenz f bestimmten zeitlich äquidistanten Abtastzeitpunkte zu der Nutzfrequenz entspricht dann also einem Wert der größer oder gleich 1,25 ist.

Des Weiteren kann die Veränderung des Betrages der stochastischen Verschiebung der durch die Abtastfrequenz f bestimmten zeitlich äquidistanten Abtastzeitpunkte in allen Ausführungsbeispielen, wie in Figur 5 dargestellt, über die Zeit betrachtet einen rechteckigen, einen sinusförmigen oder auch einen verschliffen rechteckigen Verlauf beschreiben.

## Patentansprüche

1. Verfahren zur Entstörung eines Abtastprozesses, wobei das Verfahren die folgenden Verfahrensschritte umfasst:
Abtasten eines analogen Nutzsignals (16) mit einer Abtastfrequenz f (17);
Bestimmen, ob eine Störamplitude (20) vorliegt;
bei Vorliegen einer Störamplitude (20), stochastische Verschiebung der durch die Abtastfrequenz f (17) bestimmten zeitlich äquidistanten Abtastzeitpunkte innerhalb eines Bereichs [-Δt; +Δt] (21) um die äquidistanten Abtastzeitpunkte herum, wobei Δt die maximale Verschiebung ist;
erneutes Abtasten des analogen Nutzsignals (16);
erneutes Bestimmen, ob eine Störamplitude (20) vorliegt;
bei weiterem Vorliegen einer Störamplitude (20), Veränderung des Betrages der maximalen Verschiebung |Δt|; und
erneutes Beginnen mit dem Verfahrensschritt der stochastischen Verschiebung der Abtastzeitpunkte.

2. Verfahren nach Anspruch 1, wobei in den Verfahrensschritten des Bestimmens, ob eine Störamplitude (20) vorliegt, nur dann eine Störamplitude (20) vorliegt, wenn diese größer als ein Schwellwert ist.

3. Verfahren nach Anspruch 1 oder 2, ferner umfassend den Schritt der Analog-Digital-Wandlung des abgetasteten Nutzsignals (16), wobei in den Verfahrensschritten des Bestimmens, ob eine Störamplitude (20) vorliegt, nur dann eine Störamplitude (20) vorliegt, wenn diese größer als das Rauschen (3) einer im Rahmen des Verfahrens durchgeführten Analog-Digital-Wandlung ist.

4. Verfahren nach einem der vorhergehenden Ansprüche, wobei nur dann eine Störamplitude (20) vorliegt, wenn die Störamplitude (20) im Basisband (1) des Frequenzspektrums eines abgetasteten Nutzsignals (40) vorliegt.

5. Verfahren nach einem der vorhergehenden Ansprüche, wobei die Abtastzeitpunkte dadurch bestimmt werden, dass die Phase eines Taktsignals (26) einen Schwellwert annimmt.

6. Verfahren gemäß Anspruch 5, wobei das Taktsignal (26) erzeugt wird, indem ein periodisches Taktsignal (26) mit der Periode 1/f mit Phasenrauschen (30) beaufschlagt wird.

7. Verfahren gemäß Anspruch 6, wobei das Phasenrauschen (30) 1/f-Rauschen ist.

8. Verfahren gemäß Anspruch 5, wobei das Taktsignal (26) erzeugt wird, indem ein periodisches Taktsignal (26) mit der Periode 1/f einer Frequenzmodulation unterworfen wird.

9. Verfahren nach einem der vorhergehenden Ansprüche, wobei das anfängliche Δt einem Wert von ]0; 2 %], bevorzugt ]0; 1 %] der Abtastfrequenz (17) entspricht.

10. Verfahren nach einem der vorhergehenden Ansprüche, wobei in dem Schritt der Veränderung des Betrages der maximalen Verschiebung |Δt| das Verhältnis aus dem Betrag der Veränderung des Betrags der stochastischen Verschiebung der durch die Abtastfrequenz f (17) bestimmten zeitlich äquidistanten Abtastzeitpunkte zu der Nutzfrequenz (2) größer oder gleich einem Wert von 1,25 ist.

11. Verfahren nach einem der vorhergehenden Ansprüche, insbesondere nach Anspruch 9, wobei das anfängliche Δt im Schritt der Veränderung des Bereichs [-Δt; +Δt] (21) halbiert wird.

12. Vorrichtung zur Entstörung eines Abtastprozesses, umfassend:
ein Mittel zum Abtasten eines Nutzsignals (16) mit einer Abtastfrequenz f(17);
ein Mittel zur Störamplitudenbestimmung (50), welches dazu ausgelegt ist zu bestimmen, ob dass abgetastete Nutzsignal (38) mit einer Störamplitude (20) beaufschlagt ist,
**dadurch gekennzeichnet, dass**
das Mittel zur Störamplitudenbestimmung (50) ferner dazu ausgelegt ist,
bei Vorliegen einer Störamplitude (20), die durch die Abtastfrequenz f (17) bestimmten zeitlich äquidistanten Abtastzeitpunkte innerhalb eines Bereichs [-Δt; +Δt] (21) um die äquidistanten Abtastzeitpunkte herum stochastisch zu verschieben, wobei Δt die maximale Verschiebung ist, und das Nutzsignal mit den stochastisch verschobenen Abtastzeitpunkten erneut abzutasten, und ferner dazu ausgelegt ist, bei weiterem Vorliegen einer Störamplitude (20) den Betrag der maximalen Verschiebung |Δt| zu verändern.

## Claims

1. Method for interference suppression of a sampling process, wherein the method comprises the following method steps:
sampling an analogue useful signal (16) with a sampling frequency f (17);
determining whether an interference amplitude (20) is present;
if an interference amplitude (20) is present, performing a stochastic shift of the temporally equidistant sampling instants determined by the sampling frequency f (17), within a range [-Δt; +Δt] (21) around the equidistant sampling instants, wherein Δt is the maximum shift;
once again sampling the analogue useful signal (16) ;
once again determining whether an interference amplitude (20) is present;
if an interference amplitude (20) continues to be present, changing the absolute value of the maximum shift |Δt|; and
once again beginning with the method step of performing the stochastic shift of the sampling instants.

2. Method according to Claim 1, wherein, in the method steps of determining whether an interference amplitude (20) is present, an interference amplitude (20) is present only if the latter is greater than a threshold value.

3. Method according to Claim 1 or 2, furthermore comprising the step of the analogue-to-digital conversion of the sampled useful signal (16), wherein in the method steps of determining whether an interference amplitude (20) is present, an interference amplitude (20) is present only if the latter is greater than the noise (3) of an analogue-to-digital conversion carried out in the context of the method.

4. Method according to any of the preceding claims, wherein an interference amplitude (20) is present only if the interference amplitude (20) is present in the baseband (1) of the frequency spectrum of a sampled useful signal (40).

5. Method according to any of the preceding claims, wherein the sampling instants are determined by virtue of the phase of a clock signal (26) assuming a threshold value.

6. Method according to Claim 5, wherein the clock signal (26) is generated by virtue of a periodic clock signal (26) with the period 1/f being subjected to phase noise (30).

7. Method according to Claim 6, wherein the phase noise (30) is 1/f noise.

8. Method according to Claim 5, wherein the clock signal (26) is generated by virtue of a periodic clock signal (26) with the period 1/f being subjected to a frequency modulation.

9. Method according to any of the preceding claims, wherein the initial Δt corresponds to a value of ]0; 2%], preferably ]0; 1%] of the sampling frequency (17).

10. Method according to any of the preceding claims, wherein in the step of changing the absolute value of the maximum shift |Δt|, the ratio of the absolute value of the change of the absolute value of the stochastic shift of the temporally equidistant sampling instants, determined by the sampling frequency f (17), to the useful frequency (2) is greater than or equal to a value of 1,25.

11. Method according to any of the preceding claims, in particular according to Claim 9, wherein the initial Δt is halved in the step of changing the range [-Δt; +Δt] (21).

12. Device for the interference suppression of a sampling process, comprising:
a means for sampling a useful signal (16) with a sampling frequency f (17);
a means for interference amplitude determination (50), which is designed to determine whether the sampled useful signal (38) is subjected to an interference amplitude (20),
**characterized in that**
the means for interference amplitude determination (50) is furthermore designed, if an interference amplitude (20) is present, to perform a stochastic shift of the temporally equidistant sampling instants, determined by the sampling frequency f (17), within a range [-Δt; +Δt] (21) around the equidistant sampling instants, wherein Δt is the maximum shift, and once again to sample the useful signal with the stochastically shifted sampling instants, and is furthermore designed, if an interference amplitude (20) continues to be present, to change the absolute value of the maximum shift |Δt|.

## Revendications

1. Procédé d'élimination des parasites d'un processus d'échantillonnage, dans lequel le procédé comprend les étapes de procédé consistant à :
échantillonner un signal analogique utile (16) à une fréquence d'échantillonnage f (17) ;
déterminer si une amplitude parasite (20) est présente ;
lors de la présence d'une amplitude parasite (20), décaler de manière stochastique les instants d'échantillonnage temporellement équidistants déterminés par la fréquence d'échantillonnage f (17) à l'intérieur d'une plage [-Δt ; +Δt] (21) autour des instants d'échantillonnage équidistants, dans lequel Δt est le décalage maximal ;
effectuer un nouvel échantillonnage du signal analogique utile (16) ;
effectuer une nouvelle détermination du fait de savoir si une amplitude parasite (20) est présente ;
dans le cas où une amplitude parasite est présente (20), modifier la valeur du décalage maximal |Δt| ; et recommencer l'étape de procédé de décalage stochastique des instants d'échantillonnage.

2. Procédé selon la revendication 1, dans lequel, lors des étapes de procédé permettant de déterminer si une amplitude parasite (20) est présente, une amplitude parasite (20) n'est présente que lorsque celle-ci est supérieure à une valeur de seuil.

3. Procédé selon la revendication 1 ou 2, comprenant en outre l'étape de conversion analogique-numérique du signal utile échantillonné (16), dans lequel, lors des étapes de procédé de détermination du fait de savoir si une amplitude parasite (20) est présente, une amplitude parasite (20) n'est présente que lorsque celle-ci est supérieure au bruit (3) d'une conversion analogique-numérique effectuée dans le cadre du procédé.

4. Procédé selon l'une quelconque des revendications précédentes, dans lequel une amplitude parasite (20) n'est présente que lorsque l'amplitude parasite (20) est présente dans une bande de base (1) du spectre de fréquences d'un signal utile échantillonné (40).

5. Procédé selon l'une quelconque des revendications précédentes, dans lequel les instants d'échantillonnage sont déterminés en faisant en sorte que la phase d'un signal d'horloge (26) devienne égale à une valeur de seuil.

6. Procédé selon la revendication 5, dans lequel le signal d'horloge (26) est généré en appliquant un bruit de phase (30) à un signal d'horloge périodique (26) de période 1/f.

7. Procédé selon la revendication 6, dans lequel le bruit de phase (30) est un bruit en 1/f.

8. Procédé selon la revendication 5, dans lequel le signal d'horloge (26) est généré en soumettant un signal d'horloge périodique (26) de période 1/f à une modulation de fréquence.

9. Procédé selon l'une quelconque des revendications précédentes, dans lequel le Δt initial correspond à une valeur de ]0 ; 2 %], de préférence ]0 ; 1 %] de la fréquence d'échantillonnage (17).

10. Procédé selon l'une quelconque des revendications précédentes, dans lequel, lors de l'étape de modification de la valeur du décalage maximal |Δt|, le rapport de la valeur de la modification du décalage stochastique des instants d'échantillonnage temporellement équidistants déterminés par la fréquence d'échantillonnage f (17) à la fréquence utile (2) est supérieur ou égal à une valeur de 1,25.

11. Procédé selon l'une quelconque des revendications précédentes, notamment selon la revendication 9, dans lequel le Δt initial, lors de l'étape de modification de la plage [-Δt ; +Δt] (21) est diminué de moitié.

12. Dispositif d'élimination des parasites d'un processus d'échantillonnage, comprenant :
un moyen d'échantillonnage d'un signal analogique utile (16) à une fréquence d'échantillonnage f (17) ;
un moyen de détermination d'amplitude parasite (50), qui est conçu pour déterminer si le signal utile échantillonné (38) est soumis à une amplitude parasite (20),
**caractérisé en ce que**
le moyen de détermination d'amplitude parasite (50) est en outre conçu,
lors de la présence d'une amplitude parasite (20), pour décaler de manière stochastique les instants d'échantillonnage temporellement équidistants déterminés par la fréquence d'échantillonnage f (17) à l'intérieur d'une plage [-Δt ; +Δt] (21) autour des instants d'échantillonnage équidistants, dans lequel Δt est le décalage maximal, et pour échantillonner à nouveau le signal utile aux instants d'échantillonnage décalés stochastiquement et est en outre conçu pour modifier, lorsque la présence d'une amplitude parasite (20) se poursuit, pour modifier la valeur du décalage maximal |Δt|.
